# EUROPÄISCHE PATENTANMELDUNG

(11) **EP 2 439 000 A1**
(43) Veröffentlichungstag der Anmeldung: **11.04.2012**
(21) Anmeldenummer: 10186617.6
(22) Anmeldetag: 05.10.2010
(51) Int. Cl.: B06B 1/06, H01L 41/193, H01L 41/26, B32B 3/28, B32B 27/00

(54) **Polymerschichtenverbund mit Ferroelektret-Eigenschaften und Verfahren zu dessen Herstellung**

(71) Anmelder: Bayer MaterialScience AG, 51368 Leverkusen (DE)
(72) Erfinder: Lovera-Prieto, Deliani, Dr., 51368 Leverkusen (DE); Jenninger, Werner, Dr., 51368 Leverkusen (DE)

(57) **Zusammenfassung**

Ein Polymerschichtenverbund mit Ferroelektret-Eigenschaften umfasst eine wellenförmige erste Polymerschicht (1) und eine diese unter Bildung von Hohlräumen (5) kontaktierende planare zweite Polymerschicht (2). Im Querschnitt gesehen nehmen die Hohlräume (5) eine Breite a, eine maximale Höhe h und einen Abstand b zueinander ein. Auf der den Hohlräumen (5) abgewandten Seite der ersten Polymerschicht (1) findet der Übergang zwischen den seitlichen Abschnitten (6) und den verbindenden Abschnitten (7) unter einem Übergangsradius r1 statt und auf der zugewandten Seite unter einem Übergangsradius r2. Erfindungsgemäß beträgt der Winkel α ≥ 5° bis ≤ 90°, das Verhältnis von a:b liegt in einem Bereich von ≥ 1:5 bis ≤ 20:1 und das Verhältnis von h:a in einem Bereich von ≥ 1:20 bis ≤ 5:1. Die Erfindung betrifft weiterhin ein Verfahren zur Herstellung eines erfindungsgemäßen Polymerschichtverbundes und piezoelektrisches Element, umfassend einen erfindungsgemäßen Polymerschichtverbund.

## Beschreibung

Die vorliegende Erfindung betrifft einen Polymerschichtenverbund mit Ferroelektret-Eigenschaften mit einer wellenförmigen ersten Polymerschicht und einer diese unter Bildung von Hohlräumen kontaktierenden planaren zweiten Polymerschicht. Sie betrifft weiterhin ein Verfahren zur Herstellung eines erfindungsgemäßen Polymerschichtverbundes und ein piezoelektrisches Element, umfassend einen erfindungsgemäßen Polymerschichtverbund.

Wegen ihrer vorteilhaften und gezielt einstellbaren Eigenschaften, wie zum Beispiel geringes Gewicht, thermische Leitfähigkeit, mechanische Verformbarkeit, elektrische Eigenschaften sowie Barrierefunktionen werden Polymere und Polymerverbundstoffe in einer Vielzahl von kommerziellen Anwendungen eingesetzt. Sie werden beispielsweise als Verpackungsmaterial für Lebensmittel oder sonstige Güter, als Konstruktions- oder Isolationsmaterialien beispielsweise im Bauwesen oder im Fahrzeugbau verwendet. Funktionspolymere gewinnen in zunehmendem Maße aber auch als aktive Komponenten in Sensor- oder Aktoranwendungen an Bedeutung.

Ein wichtiges Anwendungskonzept bezieht sich dabei auf den Einsatz der Polymere als elektromechanische oder piezoelektrische Wandler. Piezoelektrische Materialien sind in der Lage, einen mechanischen Druck in ein elektrisches Spannungssignal umzuwandeln. Umgekehrt kann ein an das piezoelektrische Material angelegtes elektrisches Feld in eine Änderung der Wandlergeometrie transformiert werden. Piezoelektrische Materialien werden bereits in einer Vielzahl von Anwendungen als aktive Komponenten integriert. Hierzu gehören beispielsweise strukturierte Drucksensoren für Tastaturen oder Touchpads, Beschleunigungssensoren, Mikrofone, Lautsprecher, Ultraschallwandler für Anwendungen in der Medizintechnik, der Meerestechnik oder zur Materialprüfung. In der Patentanmeldung WO 2006/053528 A1 ist beispielsweise ein elektroakustischer Wandler auf Basis eines piezoelektrischen Elements aus Polymerfolien beschrieben.

In den letzten Jahren steht zunehmend eine neue Klasse piezoelektrischer Polymere, die sogenannten Ferroelektrete, im Interesse der Forschung. Die Ferroelektrete werden auch Piezoelektrete genannt. Ferroelektrete sind Polymermaterialien mit einer Hohlraumstruktur, die elektrische Ladungen über lange Zeiträume speichern können. Die bisher bekannten Ferroelektrete weisen eine zelluläre Hohlraumstruktur auf und sind entweder als geschäumte Polymerfolien oder als Mehrschichtsysteme aus Polymerfolien oder Polymergeweben ausgebildet. Sind elektrische Ladungen entsprechend ihrer Polarität auf den unterschiedlichen Oberflächen der Hohlräume verteilt, stellt jeder geladene Hohlraum einen elektrischen Dipol dar. Werden die Hohlräume nun deformiert, bedingt dies eine Änderung der Dipolgröße und führt zu einem Stromfluss zwischen äußeren Elektroden. Die Ferroelektrete können eine piezoelektrische Aktivität zeigen, die der anderer Piezoelektrika vergleichbar ist.

In der Patentschrift US 4,654,546 ist ein Verfahren zur Herstellung von Polypropylen-Schaumfolien als Vorstufe zu einer Ferroelektretfolie beschrieben. Hierbei werden die Polymerfolien mit Füllstoffpartikeln versetzt. Als Füllstoff wird zum Beispiel Titandioxid eingesetzt. Die Polypropylenfolien werden nach dem Extrudieren biaxial gereckt, so dass sich rund um die Füllstoffpartikel kleine Hohlräume in der Folie ausbilden.

Dieses Verfahren wurde inzwischen auch auf andere Polymere angewandt. So wurde zum Beispiel in den Veröffentlichungen von M. Wegener, M. Paajanen, O. Voronina, R. Schulze, W. Wirges und R. Gerhard-Multhaupt "Voided cyclo-olefin polymer films: Ferroelectrets with high thermal stability", Proceedings, 12th International Symposium on Electrets (IEEE Service Center, Piscataway, New Jersey, USA 2005), 47-50 (2005) und Eetta Saarimäki, Mika Paajanen, Ann-Mari Savijärvi, Hannu Minkkinen, Michael Wegener, Olena Voronina, Robert Schulze, Werner Wirges und Reimund Gerhard-Multhaupt "Novel Heat Durable Electromechanical Film: Processing for Electromechanical and Electret Applications", IEEE Transactions on Dielectrics and Electrical Insulation 13, 963-972 (October 2006), die Herstellung von Ferroelektretfolien aus Cyclo-Olefin-Copolymeren (COC) und Cyclo-Olefin-Polymeren (COP) beschrieben.

Ein weiteres Verfahren zur Herstellung geschäumter Ferroelektret-Polymerfolien ist das direkte physikalische Schäumen einer homogenen Folie mit superkritischen Flüssigkeiten, zum Beispiel mit Kohlendioxid. In der Veröffentlichung Advanced Functional Materials 17, 324-329 (2007), Werner Wirges, Michael Wegener, Olena Voronina, Larissa Zirkel und Reimund Gerhard-Multhaupt "Optimized preparation of elastically soft, highly piezoelectric, cellular ferroelectrets from nonvoided poly(ethylene terephthalate) films", und in Applied Physics Letters 90, 192908 (2007), P. Fang, M. Wegener, W. Wirges, and R. Gerhard L. Zirkel "Cellular polyethylenenaphthalate ferroelectrets: Foaming in supercritical carbon dioxide, structural and electrical preparation, and resulting piezoelectricity", ist dieses Verfahren mit Polyestermaterialien sowie in Applied Physics A: Materials Science & Processing 90, 615-618 (2008), O. Voronina, M. Wegener, W. Wirges, R. Gerhard, L. Zirkel und H. Münstedt "Physical foaming of fluorinated ethylene-propylene (FEP) copolymers in supercritical carbon dioxide: single film fluoropolymer piezoelectrets" für ein Fluorpolymer FEP (Fluorinated Ethylene-Propylene Copolymer) beschrieben worden.

Die geschäumten Polymerfolien haben allerdings den Nachteil, dass sich eine breite Verteilung der Bläschengröße ergeben kann. Dadurch können bei dem anschließenden Aufladungsschritt nicht alle Blasen gleichmäßig gut aufgeladen werden.

Bei den Ferroelektret-Mehrschichtsystemen sind unter anderem Anordnungen aus harten und weichen Schichten und dazwischen eingebrachten Ladungen bekannt. In "Double-layer electret transducer", Journal of Electrostatics, Vol. 39, pp. 33-40, 1997, R. Kacprzyk, A. Dobrucki, and J. B. Gajewski, sind Mehrfachschichten aus festen Materialien mit stark unterschiedlichen Elastizitätsmodulen beschrieben. Diese haben jedoch den Nachteil, dass diese Schichtsysteme nur einen relativ geringen piezoelektrischen Effekt zeigen.

Neueste Entwicklungen auf dem Gebiet der Ferroelektrete sehen strukturierte Polymerschichten vor. In mehreren Veröffentlichungen aus den letzten Jahren sind Mehrschichtsysteme aus geschlossenen äußeren Schichten und einer porösen oder perforierten Mittelschicht beschrieben. Hierzu gehören die Artikel von Z. Hu und H. von Seggern, "Air-breakdown charging mechanism of fibrous polytetrafluoroethylene films", Journal of Applied Physics, Vol. 98, paper 014108, 2005 und "Breakdown-induced polarization buildup in porous fluoropolymer sandwiches: A thermally stable piezoelectret", Journal of Applied Physics, Vol. 99, paper 024102, 2006, sowie die Veröffentlichung von H.C. Basso, R.A.P. Altafilm, R.A.C. Altafilm, A. Mellinger, Peng Fang, W. Wirges und R. Gerhard "Three-layer ferroelectrets from perforated Teflon-PTFE films fused between two homogeneous Teflon -FEP films" IEEE, 2007 Annual Report Conference on Electrical Insulation and Dielectric Phenomena, 1-4244-1482-2/07, 453-456 (2007) und der Artikel von Jinfeng Huang, Xiaoqing Zhang, Zhongfu Xia, and Xuewen Wang "Piezoelectrets from laminated sandwiches of porous polytetrafluoroethylene films and nonporous fluoroethylenepropylene films", Journal of Applied Physics, Vol. 103, paper 084111, 2008.

Die Schichtsysteme mit einer porösen oder perforierten Mittelschicht haben gegenüber den vorstehend beschriebenen Systemen häufig größere Piezokonstanten. Dabei lassen sich die Mittelschichten jedoch manchmal nicht zuverlässig mit den festen Außenschichen laminieren. Darüber hinaus ist die Perforation der Mittelschicht in der Regel sehr zeitaufwendig.

In den Veröffentlichungen von X. Zhang, J. Hillenbrand und G. M. Sessler, "Thermally stable fluorocarbon ferroelectrets with high piezoelectric coefficient", Applied Physics A, Vol. 84, pp. 139-142, 2006 und "Ferroelectrets with improved thermal stability made from fused fluorocarbon layers", Journal of Applied Physics, Vol. 101, paper 054114, 2007, sowie in Xiaoqing Zhang, Jinfeng Huang and Zhongfu Xia "Piezoelectric activity and thermal stability of cellular fluorocarbon films", PHYSICA SCRIPTA Vol. T129 pp 274-277, 2007 ist die Strukturierung der Polymerschichten durch Aufdrücken eines Metallgitters auf einen Polymerschichtstapel aus mindestens drei in alternierender Reihenfolge übereinander gelagerten FEP- und PTFE-Schichten beschrieben. Durch das Zusammenpressen der Schichten durch das Gitter bei einer Temperatur, die über dem Schmelzpunkt von FEP und unter dem von PTFE liegt, werden die Polymerschichten entsprechend der Gitterstruktur derart miteinander verbunden, dass sich zwischen den Gitterstäben kuppelförmige oder blasenförmige Hohlräume mit rechteckiger Grundfläche bilden.

Dieses Verfahren führt jedoch zu Ferroelektreten mit unterschiedlicher Qualität, da die Bildung gleichförmiger Hohlräume vor allem bei zunehmender Schichtenanzahl nur schwer kontrolliert werden kann.

Ein anderes Verfahren zur Herstellung blasenförmiger Hohlräume unter Verwendung eines Gitters ist durch R. A. C. Altafim, H. C. Basso, R. A. P. Altafim, L. Lima, C. V. De Aquino, L. Gonalves Neto und R. Gerhard-Multhaupt in "Piezoelectrets from thermo-formed bubble structures of fluoropolymer-electret films", IEEE Transactions on Dielectrics and Electrical Insulation, Vol. 13, No. 5, pp. 979-985, 2006 beschrieben worden. Hierbei werden zwei übereinander angeordnete Teflon-FEP-Folien zwischen einem Metallgitter und einem oberen zylinderförmigen Metallteil angeordnet.

Dieser Aufbau wird mit dem Metallgitter auf ein unteres zylinderförmiges Metallteil aufgepresst, welches Öffnungen zur Anlegung eines Vakuums aufweist. Die FEP-Folien werden durch das obere Metallteil erhitzt und durch ein an das untere Metallteil angelegtes Vakuum wird die untere Folie in die Öffnungen des Gitters gezogen und entsprechende Hohlräume gebildet. Die beschriebenen Verfahren unter Verwendung eines Gitters zur Ausbildung von Hohlräumen in den Polymer-Mehrschichtverbunden sind aufwendig und schwierig in den großtechnischen Maßstab zu übertragen.

Eine weitere Herstellungsmethode für Ferroelektrete mit röhrenförmigen Hohlräumen homogener Größe und Struktur wurde von R. A. P. Altafim, X. Qiu, W. Wirges, R. Gerhard, R. A. C. Altafim, H.C. Basso, W. Jenninger und J. Wagner in dem Artikel "Template-based fluoroethylenepropylene piezoelectrets with tubular channels for transducer applications", Journal of Applied Physics 106, 014106 (2009), beschrieben. Bei dem dort beschriebenen Verfahren wird zunächst eine Sandwichanordnung zweier FEP-Folien und einer dazwischen eingelegten PTFE-Maskenfolie bereitgestellt. Der gebildete Folienstapel wird laminiert, die FEP-Folien miteinander verbunden und nachfolgend die Maskenfolie unter Freigabe der Hohlräume entfernt.

WO 2010/066348 A2 offenbart ein Verfahren zur Herstellung von Zwei- oder Mehrschicht-Ferroelektreten mit definierten Hohlräumen durch Strukturieren mindestens einer ersten Oberfläche einer ersten Polymerfolie unter Ausbildung eines Höhenprofils, Auflegen mindestens einer zweiten Polymerfolie auf die in einem ersten Schritt gebildete strukturierte Oberfläche der ersten Polymerfolie, Verbinden der Polymerfolien zu einem Polymerfolienverbund unter Ausbildung von Hohlräumen und die elektrische Aufladung der inneren Oberflächen der ausgebildeten Hohlräume mit entgegengesetzten elektrischen Ladungen. Gegenstand der Patentanmeldung sind weiterhin Ferroelektret-Mehrschichtverbunde, gegebenenfalls hergestellt nach den erfindungsgemäßen Verfahren umfassend mindestens zwei übereinander angeordnete und miteinander verbundene Polymerfolien, wobei zwischen den Polymerfolien Hohlräume ausgebildet sind. Zudem betrifft die Patentanmeldung ein piezoelektrisches Element enthaltend einen erfindungsgemäßen Ferroelektret-Mehrschichtverbund.

Ferroelektrete sind für kommerzielle Anwendungen, beispielsweise für Sensor-, Aktor- und Generatorsysteme, weiterhin von zunehmendem Interesse. Für die Wirtschaftlichkeit ist dabei eine Anwendbarkeit eines Herstellungsverfahrens im industriellen Maßstab essentiell.

Der Erfindung liegt daher die Aufgabe zu Grunde, alternative Ferroelektret-Mehrschichtverbunde sowie alternative Verfahren zur Herstellung von Ferroelektret-Mehrschichtverbunden bereitzustellen, mit denen definierte, strukturweiche Ferroelektret-Hohlraumstrukturen erzeugt werden können und die einfach und kostengünstig auch im großtechnischen und industriellen Maßstab durchführbar sind.

Diese Aufgabe wird erfindungsgemäß durch einen Polymerschichtverbund gemäß dem Anspruch 1 und ein Verfahren gemäß Anspruch 8 gelöst. Vorteilhafte Weiterbildungen sind in den Unteransprüchen angegeben.

Erfindungsgemäß vorgeschlagen wird ein Polymerschichtenverbund mit Ferroelektret-Eigenschaften, umfassend
eine wellenförmige erste Polymerschicht mit Erhebungen und Vertiefungen und eine mit den Vertiefungen der ersten Polymerschicht verbundene, planare zweite Polymerschicht,
wobei zwischen der ersten und der zweiten Polymerschicht eine Vielzahl von Hohlräumen gebildet wird,
wobei die erste Polymerschicht gegenüber der zweiten Polymerschicht in einem Winkel α geneigte seitliche Abschnitte und weiterhin die seitlichen Abschnitte verbindende Abschnitte umfasst,
wobei die erste Polymerschicht eine konstante Dicke d1 und die zweite Polymerschicht eine konstante Dicke d2 aufweisen,
wobei im Querschnitt gesehen die Hohlräume eine Breite a und eine maximale Höhe h aufweisen und zueinander einen Abstand b einnehmen,
wobei auf der den Hohlräumen abgewandten Seite der ersten Polymerschicht der Übergang zwischen den seitlichen Abschnitten und den verbindenden Abschnitten unter einem Übergangsradius r1 stattfindet und
auf der den Hohlräumen zugewandten Seite der ersten Polymerschicht der Übergang zwischen den seitlichen Abschnitten und den verbindenden Abschnitten unter einem Übergangsradius r2 stattfindet und
wobei der Winkel α ≥ 5° bis ≤ 90° beträgt, das Verhältnis von a:b in einem Bereich von ≥ 1:5 bis ≤ 20:1 liegt und das Verhältnis von h:a in einem Bereich von ≥ 1:20 bis ≤ 5:1 liegt.

Im Rahmen der vorliegenden Erfindung bedeuten Ferroelektret-Eigenschaften, dass innerhalb von Hohlräumen einander entgegengesetzte elektrische Ladungen auf gegenüberliegenden Oberflächen des Hohlraums angeordnet sind. Wie bereits ausgeführt, stellt jeder Hohlraum damit einen elektrischen Dipol dar. Bei einer Deformation des Hohlraums kommt es zu einer Änderung der Dipolgröße und es kann ein elektrischer Strom zwischen entsprechend angeschlossenen äußeren Elektroden fließen.

Es ist vorgesehen, dass die erste Polymerschicht wellenförmig ausgeführt ist, wobei Erhebungen (Wellenberge) und Vertiefungen (Wellentäler) vorliegen. Unter "wellenförmig" ist hierbei eine regelmäßige oder unregelmäßige Abfolge von Erhebungen und Vertiefungen mit dazwischen liegenden verbindenden Abschnitten zu verstehen.

Durch die Verbindung der Vertiefungen mit der planaren zweiten Polymerschicht werden Hohlräume gebildet, welche die elektrischen Dipole bilden können. Selbstverständlich sollten die Ränder des Schichtenverbundes geschlossen werden, wenn insgesamt abgeschlossene Hohlräume erwünscht sind.

Es ist bevorzugt, dass im erfindungsgemäßen Polymerschichtenverbund neben der ersten und zweiten Polymerschicht keine weiteren Polymerschichten vorhanden sind.

Seitliche Abschnitte der wellenförmigen ersten Polymerschicht sind gegenüber der planaren zweiten Polymerschicht in einem Winkel α geneigt. Weiterhin sind zwischen den seitlichen Abschnitten verbindende Abschnitte vorgesehen. Es ist bevorzugt, dass die seitlichen Abschnitte, bis auf die Übergänge zu den verbindenden Abschnitten, gerade sind. Vorzugsweise ergibt sich in einer vereinfachten Betrachtung ein trapezförmiger Querschnitt der Hohlräume. Die Hohlräume weisen keinen halbkreisförmigen Querschnitt auf. Für den Fall, dass beim Zusammentreffen der Vertiefungen der ersten Polymerschicht mit der zweiten Polymerschicht technisch unvermeidliche Krümmungen auftreten, definiert sich der Winkel α als der Winkel, den gerade Strecken der Seitenabschnitte zur planaren zweiten Polymerschicht einnehmen.

Wenn der Winkel α < 90° ist, so sind die erfindungsgemäßen Schichtenverbunde strukturweich und weisen unter anderem gegenüber vergleichbaren Systemen mit rechtwinkligen Hohlräumen eine größere piezoelektrische Konstante d₃₃ auf.

Es ist erfindungsgemäß weiterhin vorgesehen, dass die Dicken d1 und d2 der ersten und zweiten Polymerschicht konstant sind. In den Begriff "konstant" mit eingeschlossen sind technisch unvermeidliche Schwankungen um höchstens ± 10% der Dicke, wobei Schwankungen um höchstens ± 5% der Dicke bevorzugt sind.

Im Querschnitt gesehen weisen die Hohlräume eine Breite a auf. Die Breite wird so definiert, dass sie den Abstand der gegenüberliegenden Kontaktstellen der Vertiefungen der ersten Polymerschicht mit der planaren zweiten Polymerschicht darstellt. Um geneigten Seitenabschnitten der Hohlräume Rechnung zu tragen, wird die Höhe der Hohlräume zweckmäßigerweise als die maximale Höhe h (gemessen senkrecht zur Breite) angegeben. Die Hohlräume werden weiterhin durch Bereiche getrennt, in denen die Vertiefungen der ersten Polymerschicht unmittelbar auf der zweiten Polymerschicht liegen. Diese Bereiche weisen eine Breite b auf, die dementsprechend den Abstand der Hohlräume darstellt.

Die Krümmung der Übergänge zwischen seitlichen und verbindenden Abschnitten der ersten Polymerschicht wird gemäß der vorstehenden Definitionen durch die Übergangsradien r1 und r2 beschrieben. Die Übergangsradien beschreiben hierbei die Radien an den Innenseiten der Krümmungen. Das Verhältnis von r1:h und/oder von r2:h kann beispielsweise in einem Bereich von ≥ 1:5 bis ≤ 5:1 liegen.

Vorzugsweise liegt das Verhältnis von a:b in einem Bereich von ≥ 1:4 bis ≤ 10:1 liegt und mehr bevorzugt von ≥ 1:1 bis ≤ 6:1. Das Verhältnis von h:a beträgt bevorzugt ≥ 1:10 bis ≤ 4:1 liegt und mehr bevorzugt von ≥ 1:6 bis ≤ 1:1. Weiterhin liegt vorzugsweise das Verhältnis von r1:h und/oder r2:h ≥ 1:4 bis ≤ 4:1 und mehr bevorzugt ≥ 1:3 bis ≤ 3:1.

Ausführungsformen der Erfindung werden nachfolgend geschildert, wobei die einzelnen Ausführungsformen in beliebiger Weise miteinander kombiniert werden können, sofern sich nicht aus dem Zusammenhang eindeutig etwas anderes ergibt.

In einer Ausführungsform des erfindungsgemäßen Polymerschichtenverbundes betragen: die Dicke d1 ≥ 10 µm bis ≤ 250 µm, die Dicke d2 ≥ 10 µm bis ≤ 250 µm, die Breite a ≥ 10 µm bis ≤ 3 mm, der Abstand b ≥ 10 µm bis ≤ 3 mm, die maximale Höhe h ≥ 10 µm bis ≤ 500 µm und der Winkel α ≥ 5° bis ≤ 80°.

Vorzugsweise betragen: die Dicke d1 ≥ 30 µm bis ≤ 200 µm, die Dicke d2 ≥ 30 µm bis ≤ 200 µm, die Breite a ≥ 50 µm bis ≤ 2 mm, der Abstand b ≥ 50 µm bis ≤ 2 mm, die maximale Höhe h ≥ 50 µm bis ≤ 300 µm und der Winkel α ≥ 15° bis ≤ 75°.

Mehr bevorzugt betragen: die Dicke d1 ≥ 40 µm bis ≤ 100 µm, die Dicke d2 ≥ 40 µm bis ≤ 100 µm, die Breite a ≥ 100 µm bis ≤ 1 mm, der Abstand b ≥ 100 µm bis ≤ 1 mm, die maximale Höhe h ≥ 100 µm bis ≤ 200 µm und der Winkel α ≥ 35° bis ≤ 70°.

In einer weiteren Ausführungsform des erfindungsgemäßen Schichtenverbundes umfasst die erste und/oder zweite Polymerschicht ein Material, das ausgewählt ist aus der Gruppe umfassend Polycarbonat, perfluorierte oder teilfluorierte Polymere und Co-Polymere, Polytetrafluorethylen (PTFE), Fluorethylenpropylen (FEP), Perfluoralkoxyethylen (PFA), Polyester, Polyethylenterephthalat (PET), Polyethylennaphthalat (PEN), Polyimid, Polyetherimid, Polyether, Polymethyl(meth)acrylat, Cyclo-Olefin-Polymere, Cyclo-Olefin-Copolymere (COC) und/oder Polyolefine (insbesondere Polypropylen). Mit diesen Materialien können gute bis sehr gute Piezoaktivitäten erzielt werden. Die erfindungsgemäß breite Materialauswahl kann vorteilhafterweise auch eine Anpassung auf bestimmte Anwendungen ermöglichen.

In einer weiteren Ausführungsform des erfindungsgemäßen Schichtenverbundes sind die Hohlräume mit Gasen gefüllt, die ausgewählt sind aus der Gruppe umfassend Stickstoff (N₂), Distickstoffmonoxid (N₂O) und/oder Schwefelhexafluorid (SF₆). Durch die Gasbefüllung können vorteilhafterweise bei den erfindungsgemäßen Polymerschichtenverbunden durch Polung nochmals deutlich höhere Piezokonstanten erzielt werden.

In einer weiteren Ausführungsform des erfindungsgemäßen Schichtenverbundes weisen die Hohlräume keine Verzweigungen auf. Vorzugsweise sind die Hohlräume in Längsrichtung linear ausgeführt.

In einer weiteren Ausführungsform des erfindungsgemäßen Schichtenverbundes verlaufen die verbindenden Abschnitte parallel zur zweiten Polymerschicht. Die Breite der gerade verlaufenden Teile der verbindenden Abschnitte im Querschnitt gesehen lässt sich aus der Kenntnis der Breite a, der Höhe h und des Winkels α berechnen. Vorzugsweise beträgt die Breite dieser gerade verlaufenden Teile ≥30% bis ≤ 80% der Breite a.

In einer weiteren Ausführungsform des erfindungsgemäßen Schichtenverbundes sind die Hohlräume von einer Seite zur in Flächenrichtung gegenüberliegenden Seite des

Polymerschichtverbundes durchgehend ausgeführt. Hierunter ist zu verstehen, dass in Längsrichtung der Hohlräume in ihrem Verlauf keine Unterbrechungen vorgesehen sind. Vorzugsweise sind die Hohlräume lineare, durchgehende Kanäle.

In einer weiteren Ausführungsform des erfindungsgemäßen Schichtenverbundes umfasst der Polymerschichtenverbund weiterhin eine oder mehrere Elektroden. Insbesondere können die erfindungsgemäßen Polymerschichtverbunde auf den nach außen gerichteten Oberflächen der Polymerfolien mindestens teilweise eine leitende Beschichtung aufweisen. Diese leitenden Bereiche können als Elektroden genutzt werden. Die leitende Beschichtung, das heißt die Elektroden, können dabei flächig und/oder auch strukturiert aufgebracht werden. Eine strukturierte leitende Beschichtung kann beispielsweise als eine Aufbringung in Streifen oder in Gitterform ausgestaltet sein. Hierdurch kann zusätzlich die Empfindlichkeit des Polymerschichtverbundes beeinflusst und auf bestimmte Anwendungen angepasst werden.

Bei den ausgewählten Elektrodenmaterialien kann es sich um dem Fachmann bekannte leitfähige Materialien handeln. Erfindungsgemäß kommen hierfür beispielsweise Metalle, Metall-Legierungen, leitfähige Oligo- oder Polymere, wie zum Beispiel Polythiophene, Polyaniline, Polypyrrole, leitfähige Oxide, wie zum Beispiel Mischoxide wie ITO, oder mit leitfähigen Füllstoffen gefüllte Polymere in Frage. Als Füllstoffe für mit leitfähigen Füllstoffen gefüllte Polymere kommen beispielsweise Metalle, leitfähige Kohlenstoff basierte Materialien, wie zum Beispiel Ruß, Kohlenstoffnanoröhrchen (carbon nanotubes, CNTs) oder wiederum leitfähige Oligo- oder Polymere, in Frage. Der Füllstoffgehalt der Polymere liegt dabei oberhalb der Perkolationsschwelle, so dass die leitfähigen Füllstoffe durchgehende elektrisch leitfähige Pfade ausbilden.

Die Elektroden können durch an sich bekannte Verfahren, beispielsweise durch eine Metallisierung der Oberflächen, durch Sputtern, Aufdampfen, Chemical Vapor Deposition (CVD), Drucken, Rakeln, Lackschleudern (Spin-Coating), Aufkleben oder Aufdrücken einer leitenden Schicht in vorgefertigter Form oder durch eine Sprühelektrode aus einem leitenden Kunststoff realisiert werden. Die Elektroden können dabei strukturiert, beispielsweise in Streifen oder in Gitterform, ausgestaltet sein. Beispielsweise können nach einer Ausgestaltung der Erfindung die Elektroden auch derart strukturiert sein, dass der Polymerschichtverbund als elektromechanischer Wandler aktive und passive Bereiche aufweist. Beispielsweise können die Elektroden derart strukturiert sein, dass, insbesondere in einem Sensor-Modus, die Signale ortsaufgelöst detektiert und/oder, insbesondere in einem Aktuator-Modus, die aktiven Bereiche gezielt angesteuert werden können. Dies kann beispielsweise dadurch erzielt werden, dass die aktiven Bereiche mit Elektroden versehen sind, wohingegen die passiven Bereiche keine Elektroden aufweisen.

Nach einer weiteren vorteilhaften Ausgestaltung der Erfindung ist zudem vorgesehen, dass zwei oder mehr Polymerschichtverbunde mit gleich gepolter leitender Schicht, das heißt also Elektrode, verbunden werden können. Mit anderen Worten kann zwischen zwei erfindungsgemäßen Polymerschichtverbunden eine Zwischenelektrode gebildet werden, die gegen die beiden Elektroden auf den dann äußeren Oberflächen geschaltet werden kann. Hierdurch können die Ferroelektret-Mehrschichtverbunde in Reihe geschaltet und der erzielbare piezoelektrische Effekt verdoppelt beziehungsweise vervielfacht werden.

Die erfindungsgemäßen Polymerschichtverbunde enthalten bevorzugt zwei Elektroden. Bei elektromechanischen Wandlern mit mehr als zwei Elektroden kann es sich beispielsweise um Stapelaufbauten aus mehreren, vorzugsweise erfindungsgemäß hergestellten, Polymerschichtverbund-Systemen handeln.

Die vorliegende Erfindung betrifft weiterhin ein Verfahren zur Herstellung eines erfindungsgemäßen Polymerschichtenverbundes, umfassend die Schritte:
(A) Bereitstellen einer ersten Polymerschicht und einer zweiten Polymerschicht, wobei die erste Polymerschicht eine konstante Dicke d1 und die zweite Polymerschicht eine konstante Dicke d2 aufweisen;
(B) Wellenförmiges Verformen der ersten Polymerschicht unter Ausbildung von Erhebungen und Vertiefungen;
(C) Anordnen der zweiten Polymerschicht auf den Vertiefungen der ersten Polymerschicht;
(D) Verbinden der zweiten Polymerschicht mit den Vertiefungen der ersten Polymerschicht, wobei zwischen der ersten und der zweiten Polymerschicht eine Vielzahl von Hohlräumen gebildet wird, wobei im Querschnitt gesehen die Hohlräume eine Breite a und eine maximale Höhe h aufweisen und zueinander einen Abstand b einnehmen;
(E) Elektrisches Aufladen der den Hohlräumen zugewandten Oberflächen der ersten und zweiten Polymerschicht;
wobei das Verformen der ersten Polymerschicht in Schritt (B) derart geschieht, dass in einem Winkel α zur Horizontalen geneigte seitliche Abschnitte und weiterhin die seitlichen Abschnitte verbindende Abschnitte gebildet werden,
wobei nach dem Verbinden der zweiten Polymerschicht mit den Vertiefungen der ersten Polymerschicht in Schritt (D) auf der den Hohlräumen abgewandten Seite der ersten

Polymerschicht ein Übergang zwischen den seitlichen Abschnitten und den verbindenden Abschnitten mit einem Übergangsradius r1 gebildet wird und auf der den Hohlräumen zugewandten Seite der ersten Polymerschicht ein Übergang zwischen den seitlichen Abschnitten und den verbindenden Abschnitten mit einem Übergangsradius r2 gebildet wird und
wobei der Winkel α ≥ 5° bis ≤ 90° beträgt, das Verhältnis von a:b in einem Bereich von ≥ 1:5 bis ≤ 20:1 liegt und das Verhältnis von h:a in einem Bereich von ≥ 1:20 bis ≤ 5:1 liegt.

Die Reihenfolge der Schritte (A) und (B) ist zunächst nicht gesondert festgelegt. So darf selbstverständlich auch eine bereits wellenförmig verformte erste Polymerschicht bereitgestellt werden. Die Verformung der ersten Polymerschicht (Schritt (B)) kann dementsprechend auch räumlich und zeitlich getrennt von den übrigen Schritten erfolgen. Das Bereitstellen der Polymerschichten kann zweckmäßigerweise direkt von einer Rolle erfolgen, so dass ein "roll-to-roll"-Prozess ermöglicht wird.

Es ist beispielsweise möglich, dass das wellenförmige Verformen in Schritt (B) mit einer entsprechend geformten welligen Düse während einer Extrusion erfolgt.

Nach einer Ausgestaltung des erfindungsgemäßen Verfahrens kann vor und/oder nach der elektrischen Aufladung der inneren Oberflächen der Hohlräume in Schritt (E) die Aufbringung von Elektroden an den äußeren Oberflächen des Polymerschichtenverbunds erfolgen. Unter der Aufbringung von Elektroden an den äußeren Oberflächen wird die Bereitstellung einer leitenden Oberflächenbeschichtung in mindestens einem Teilbereich, insbesondere auf den nach außen gerichteten Oberflächen des Polymerschichtenverbunds verstanden. Die Elektroden werden bevorzugt auf kompakten oder nicht-strukturierten Oberflächen der eingesetzten Polymerfolien angeordnet.

Hinsichtlich weiterer Details und Vorteile des erfindungsgemäßen Verfahrens wird auf die Ausführungen zum erfindungsgemäßen Polymerschichtenverbund verwiesen.

In einer Ausführungsform des erfindungsgemäßen Verfahrens erfolgt das wellenförmige Verformen der ersten Polymerschicht in Schritt (B) mittels Prägen. Gleichermaßen bevorzugt kann der Prägeprozess unter Verwendung einer strukturierten Walze oder mittels eines Prägestempels erfolgen. Die Strukturierung kann direkt nach einer Extrusion der Folien oder auch als Einzelprozess, beispielsweise in einer Heißpresse, erfolgen. Die jeweiligen Polymerfolien können von beiden Oberflächenseiten mit einem Prägewerkzeug bearbeitet werden. Beispielsweise kann eine Polymerfolie von ihrer Ober- und ihrer Unterseite mit jeweils einer strukturierten Walze geprägt und damit strukturiert werden.

In einer weiteren Ausführungsform des erfindungsgemäßen Verfahrens erfolgt das wellenförmige Verformen der ersten Polymerschicht in Schritt (B), indem die erste Polymerschicht auf eine Temperatur unterhalb der Glasübergangstemperatur T_{g} des Polymers der Polymerschicht erwärmt wird und anschließend unter Druckeinwirkung in einem Formwerkzeug verformt wird. Die Glasübergangstemperatur wird hierbei mittels DSC gemäß DIN 65467 bei einer Aufheizrate von 20 K/min bestimmt. Man kann zum Beispiel auf eine Temperatur von ≥ 80% bis ≤ 99% oder ≥ 90% bis ≤ 95% der Glasübergangstemperatur erwärmen.

Vorzugsweise erfolgt die Druckeinwirkung durch Beaufschlagen mit einem Gas, beispielsweise Druckluft oder Stickstoff. So kann eine Polymerfolie entsprechend erwärmt und dann schlagartig durch Beaufschlagung mit Pressluft unter einem Druck von ≥ 20 bar bis ≤ 300 bar verformt werden. Beispielsweise können Polycarbonatfolien (zum Beispiel Macrofol® der Bayer MaterialScience AG) knapp unter die Glastemperatur auf ≥ 130 °C bis ≤ 140 °C erwärmt werden. Danach können die Folien mit einem Luftdruck von 250 bar beaufschlagt, auf ein Formwerkzeug gepresst werden und können sich der Werkzeugkontur anpassen und dauerhaft verformt werden.

Ein analoges Verfahren ist insbesondere bei der wiederholgenauen Verformung von bedruckten Kunststoff-Folien bereits etabliert und beispielsweise in der Offenlegungsschrift DE 39 05 177 A1 beschrieben. Eine Polymerfolie kann dabei auf einem Palettensystem positioniert, bei Bedarf erwärmt und in einem entsprechenden Formwerkzeug über einem vortemperierten Kontureinsatz durch Druckbeaufschlagung verformt werden. Dieser Hochdruckverformungsprozess wird auch als High Pressure Forming (HPF) oder HPF-Prozess bezeichnet. Vorteilhafterweise kann erfindungsgemäß auch eine analog aufgebaute Vorrichtung zu der in der DE 39 05 177 A1 beschriebenen zur Verformung der Polymerfolien eingesetzt werden.

Die genannten Verformungsvarianten haben den Vorteil, dass positionsgenau die Übertragung des jeweils gewünschten Profils auf die Polymerfolien ermöglicht wird. Sowohl Form als auch Dimensionierung der danach ausgebildeten Hohlräume ist mit den vorstehend genannten Methoden vorteilhafterweise nahezu frei wählbar und kann in Abhängigkeit mit den Folienmaterialen und deren Eigenschaften und der jeweiligen Foliendicke auf die gewünschten mechanischen und elektrischen Anforderungen der jeweiligen Anwendung angepasst werden. Die genannten Methoden haben weiterhin den Vorteil, dass sie automatisierbar sind und gegebenenfalls als kontinuierlicher Prozess durchgeführt werden können.

In einer weiteren Ausführungsform des erfindungsgemäßen Verfahrens erfolgt das Verbinden der zweiten Polymerschicht mit den Vertiefungen der ersten Polymerschicht in Schritt (D) durch Laminieren, Kleben, Klammern, Klemmen, Schrauben oder Nieten.

Die Verbindung der Polymerschichten durch Laminieren kann insbesondere thermisch, unter erhöhtem Druck und/oder mittels Ultraschall und/oder mittels Bestrahlung mit ultraviolettem Licht oder Infrarot-Licht durchgeführt werden. Vor dem Laminieren kann das Material der ersten strukturierten Polymerschicht und/oder das Material der zweiten Polymerfolie, die auch mit anderen Worten eine Abdeckung der ersten Folie bildet, vollständig verfestigt, beispielsweise vollständig getrocknet und/oder vollständig vernetzt, und /oder vollständig erstarrt und/oder vollständig kristallisiert werden. Hierdurch kann die Formbeständigkeit des entstehenden, Hohlräume umfassenden Polymerschichtenverbunds verbessert werden.

Die Verbindung der Polymerschichten mittels einer Klebung kann beispielsweise mit Acrylatklebstoff erfolgen. Alternativ ist es auch möglich, insbesondere bei der Verbindung von Polymerschichten aus gleichem Material, die Verbindung durch Aufbringen eines guten Lösungsmittels oder einer Lösungsmittelzusammensetzung für das jeweilige Polymermaterial auf eine oder beide Folien, nachfolgendes Zusammendrücken der Folien und Verdunsten des Lösungsmittels zu erzielen. Es ist zum Beispiel möglich, Polycarbonatfolien mit Methylenchlorid zu verkleben. Ein Vorteil bei der Verbindung durch Lösungsmittel ist, dass keine thermische Belastung auftritt und gerade bei thermisch verformbaren Polymermaterialien die Formbeständigkeit verbessert und ein Kollabieren der ausgebildeten Hohlräume vermieden werden kann.

In einer weiteren Ausgestaltung können die Polymerschichten auch zusätzlich zur Laminierung durch eine Verklebung miteinander verbunden werden. Diese Verklebung kann beispielsweise mittels Acrylatkleber hergestellt werden. Hierdurch kann die mechanische Verbindung der Polymerschichten unterstützt und verbessert werden.

In einer weiteren Ausführungsform des erfindungsgemäßen Verfahrens geschieht das elektrische Aufladen in Schritt (E) mittels direkter Aufladung oder Coronaentladung. Insbesondere kann das Aufladen durch eine Zweielektronen-Corona-Anordnung erfolgen. Dabei kann die Nadelspannung ≥ 20 kV, ≥ 25 kV und insbesondere ≥ 30 kV betragen. Die Aufladezeit kann dabei ≥ 20 s, ≥ 25 s und insbesondere ≥ 30 s betragen.

Unter "direkter Aufladung" ist hierbei ein Aufladen zu verstehen, wenn nach der Aufbringung von Elektroden auf den äußeren Oberflächen des Polymerschichtenverbundes eine direkte Aufladung durch Anlegung einer elektrischen Spannung erfolgt. Vor der Aufbringung von Elektroden kann eine Polung der sich gegenüberliegenden Seiten der Hohlräume durch eine Corona-Entladung realisiert werden. Eine Corona-Behandlung ist vorteilhafterweise auch großtechnisch gut einsetzbar. Erfindungsgemäß ist es auch möglich, zunächst auf einer Oberfläche eine leitende Oberflächenbeschichtung bereitzustellen, den Polymerschichtenverbund dann aufzuladen und abschließend eine zweite Elektrode auf der gegenüberliegenden äußeren Oberfläche aufzubringen.

In einer weiteren Ausführungsform des erfindungsgemäßen Verfahrens werden vor dem elektrischen Aufladen in Schritt (E) die Hohlräume (5) mit Gasen gefüllt, die ausgewählt sind aus der Gruppe umfassend Stickstoff, Stickstoffmonoxid und/oder Schwefelhexafluorid. Wie bereits geschildert, können durch die Gasbefüllung vorteilhafterweise bei den erfindungsgemäßen Polymerschichtenverbunden durch Polung nochmals deutlich höhere Piezokonstanten erzielt werden.

Ein weiterer Gegenstand der vorliegenden Erfindung ist ein piezoelektrisches Element, umfassend einen erfindungsgemäßen Polymerschichtenverbund. Dieses piezoelektrische Element kann besonders bevorzugt ein Sensor-, Aktor oder Generatorelement sein. Vorteilhafterweise kann die Erfindung in einer Vielzahl von verschiedensten Anwendungen im elektromechanischen und elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie verwirklicht werden.

Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden.

Die vorliegende Erfindung wird unter Bezugnahme auf die nachfolgende Zeichnung weiter erläutert, ohne darauf beschränkt zu sein. Es zeigt:

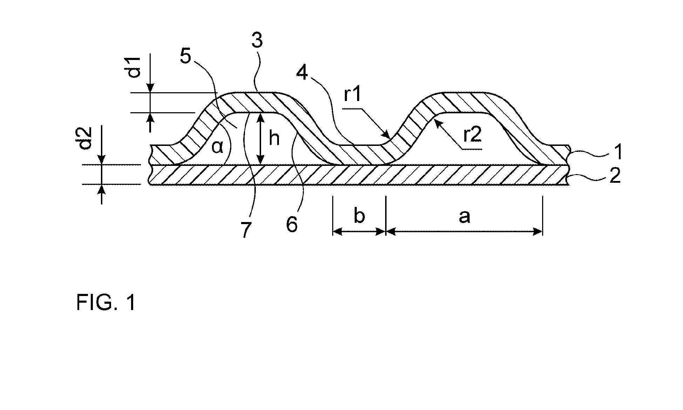

FIG. 1 einen erfindungsgemäßen Polymerschichtenverbund
FIG. 1 zeigt zum besseren Verständnis insbesondere der Bemaßung einen erfindungsgemäßen Polymerschichtenverbund in Querschnittsansicht mit einer wellenförmigen ersten Polymerschicht 1 und einer planaren zweiten Polymerschicht 2. Die Dicke d1 der ersten Polymerschicht 1 und die Dicke d2 der zweiten Polymerschicht 2 sind konstant.

Aufgrund einer vorhergehenden Verformung weist die erste Polymerschicht 1 Erhebungen 3 und Vertiefungen 4 auf. Die Vertiefungen 4 bilden die Kontaktstellen zur zweiten Polymerschicht 2, so dass Hohlräume 5 gebildet werden. Seitliche Abschnitte 6 der ersten Polymerschicht 1 werden durch verbindende Abschnitte 7 untereinander verbunden.

Der gerade Teil des seitlichen Abschnitts 6 bildet mit der planaren zweiten Polymerschicht 2 den Winkel α. Die Hohlräume 5 weisen eine Breite a auf, welche den Abstand der gegenüberliegenden Kontaktstellen der Vertiefungen 4 der ersten Polymerschicht 1 mit der planaren zweiten Polymerschicht 2 darstellt. Entsprechend trennen diejenigen Bereiche, in denen die Vertiefungen 4 der ersten Polymerschicht 1 die zweite Polymerschicht 2 direkt kontaktieren, die Hohlräume 5 mit einem Abstand b voneinander. Der Abstand b kann somit auch als die Breite der Vertiefungen angesehen werden.

Auf der den Hohlräumen 5 abgewandten Seite der ersten Polymerschicht 1 findet der Übergang zwischen den seitlichen Abschnitten 6 und den verbindenden Abschnitten 7 unter einem Übergangsradius r1 statt. Der Übergang zwischen den seitlichen Abschnitten 6 und den verbindenden Abschnitten 7 auf der den Hohlräumen 5 zugewandten Seite der ersten Polymerschicht 1 findet unter einem Übergangsradius r2 statt.

## Patentansprüche

1. Polymerschichtenverbund mit Ferroelektret-Eigenschaften, umfassend eine wellenförmige erste Polymerschicht (1) mit Erhebungen (3) und Vertiefungen (4) und eine mit den Vertiefungen (4) der ersten Polymerschicht (1) verbundene, planare zweite Polymerschicht (2),
wobei zwischen der ersten (1) und der zweiten (2) Polymerschicht eine Vielzahl von Hohlräumen (5) gebildet wird,
wobei die erste Polymerschicht (1) gegenüber der zweiten Polymerschicht (2) in einem Winkel α geneigte seitliche Abschnitte (6) und weiterhin die seitlichen Abschnitte (6) verbindende Abschnitte (7) umfasst,
wobei die erste Polymerschicht (1) eine konstante Dicke d1 und die zweite Polymerschicht (2) eine konstante Dicke d2 aufweisen,
wobei im Querschnitt gesehen die Hohlräume (5) eine Breite a und eine maximale Höhe h aufweisen und zueinander einen Abstand b einnehmen,
wobei auf der den Hohlräumen (5) abgewandten Seite der ersten Polymerschicht (1) der Übergang zwischen den seitlichen Abschnitten (6) und den verbindenden Abschnitten (7) unter einem Übergangsradius r1 stattfindet und
auf der den Hohlräumen (5) zugewandten Seite der ersten Polymerschicht (1) der Übergang zwischen den seitlichen Abschnitten (6) und den verbindenden Abschnitten (7) unter einem Übergangsradius r2 stattfindet,
**dadurch gekennzeichnet, dass**
der Winkel α ≥ 5° bis ≤ 90° beträgt, das Verhältnis von a:b in einem Bereich von ≥ 1:5 bis ≤ 20:1 liegt und das Verhältnis von h:a in einem Bereich von ≥ 1:20 bis ≤ 5:1 liegt.

2. Polymerschichtenverbund nach Anspruch 1,
**dadurch gekennzeichnet, dass**
die Dicke d1 ≥ 10 µm bis ≤ 250 µm beträgt,
die Dicke d2 ≥ 10 µm bis ≤ 250 µm beträgt,
die Breite a ≥ 10 µm bis ≤ 3 mm beträgt,
der Abstand b ≥ 10 µm bis ≤ 3 mm beträgt,
die maximale Höhe h ≥ 10 µm bis ≤ 500 µm beträgt und
der Winkel α ≥ 5° bis ≤ 80° beträgt.

3. Polymerschichtverbund nach Anspruch 1 oder 2,
**dadurch gekennzeichnet, dass**
die erste und/oder zweite Polymerschicht ein Material umfasst, das ausgewählt ist aus der Gruppe umfassend Polycarbonat, perfluorierte oder teilfluorierte Polymere und CoPolymere, Polytetrafluorethylen, Fluorethylenpropylen, Perfluoralkoxyethylen, Polyester, Polyethylenterephthalat, Polyethylennaphthalat, Polyimid, Polyetherimid, Polyether, Polymethyl(meth)acrylat, Cyclo-Olefin-Polymere, Cyclo-Olefin-Copolymere und/oder Polyolefine.

4. Polymerschichtverbund nach einem der Ansprüche 1 bis 3,
**dadurch gekennzeichnet, dass**
die Hohlräume (5) mit Gasen gefüllt sind, die ausgewählt sind aus der Gruppe umfassend Stickstoff, Distickstoffmonoxid und/oder Schwefelhexafluorid.

5. Polymerschichtverbund nach einem der Ansprüche 1 bis 4,
**dadurch gekennzeichnet, dass**
die Hohlräume (5) keine Verzweigungen aufweisen.

6. Polymerschichtverbund nach einem der Ansprüche 1 bis 5,
**dadurch gekennzeichnet, dass**
die verbindenden Abschnitte (7) parallel zur zweiten Polymerschicht (2) verlaufen.

7. Polymerschichtverbund nach einem der Ansprüche 1 bis 6,
**dadurch gekennzeichnet, dass**
der Polymerschichtenverbund eine oder mehrere Elektroden umfasst.

8. Verfahren zur Herstellung eines Polymerschichtenverbundes nach einem der Ansprüche 1 bis 7, umfassend die Schritte:
(A) Bereitstellen einer ersten Polymerschicht (1) und einer zweiten Polymerschicht (2), wobei die erste Polymerschicht (1) eine konstante Dicke d1 und die zweite Polymerschicht (2) eine konstante Dicke d2 aufweisen;
(B) Wellenförmiges Verformen der ersten Polymerschicht (1) unter Ausbildung von Erhebungen (3) und Vertiefungen (4);
(C) Anordnen der zweiten Polymerschicht (2) auf den Vertiefungen (4) der ersten Polymerschicht (1);
(D) Verbinden der zweiten Polymerschicht (2) mit den Vertiefungen (4) der ersten Polymerschicht (1), wobei zwischen der ersten (1) und der zweiten (2) Polymerschicht eine Vielzahl von Hohlräumen (5) gebildet wird, wobei im Querschnitt gesehen die Hohlräume (5) eine Breite a und eine maximale Höhe h aufweisen und zueinander einen Abstand b einnehmen;
(E) Elektrisches Aufladen der den Hohlräumen (5) zugewandten Oberflächen der ersten (1) und zweiten (2) Polymerschicht;
wobei das Verformen der ersten Polymerschicht (1) in Schritt (B) derart geschieht, dass in einem Winkel α zur Horizontalen geneigte seitliche Abschnitte (6) und weiterhin die seitlichen Abschnitte (5) verbindende Abschnitte (7) gebildet werden,
wobei nach dem Verbinden der zweiten Polymerschicht (2) mit den Vertiefungen (4) der ersten Polymerschicht (1) in Schritt (D) auf der den Hohlräumen (5) abgewandten Seite der ersten Polymerschicht (1) ein Übergang zwischen den seitlichen Abschnitten (6) und den verbindenden Abschnitten (7) mit einem Übergangsradius r1 gebildet wird und auf der den Hohlräumen (5) zugewandten Seite der ersten Polymerschicht (1) ein Übergang zwischen den seitlichen Abschnitten (6) und den verbindenden Abschnitten (7) mit einem Übergangsradius r2 gebildet wird,
**dadurch gekennzeichnet, dass**
der Winkel α ≥ 5° bis ≤ 90° beträgt, das Verhältnis von a:b in einem Bereich von ≥ 1:5 bis ≤ 20:1 liegt und das Verhältnis von h:a in einem Bereich von ≥ 1:20 bis ≤ 5:1 liegt.

9. Verfahren nach Anspruch 8,
**dadurch gekennzeichnet, dass**
das wellenförmige Verformen der ersten Polymerschicht (1) in Schritt (B) mittels Prägen erfolgt.

10. Verfahren nach Anspruch 8 oder 9,
**dadurch gekennzeichnet, dass**
das wellenförmige Verformen der ersten Polymerschicht (1) in Schritt (B) erfolgt, indem die erste Polymerschicht (1) auf eine Temperatur unterhalb der Glasübergangstemperatur T_{g} des Polymers der Polymerschicht erwärmt wird und anschließend unter Druckeinwirkung in einem Formwerkzeug verformt wird.

11. Verfahren nach Anspruch 10,
**dadurch gekennzeichnet, dass**
die Druckeinwirkung durch Beaufschlagen mit einem Gas erfolgt.

12. Verfahren nach einem der Ansprüche 8 bis 11,
**dadurch gekennzeichnet, dass**
das Verbinden der zweiten Polymerschicht (2) mit den Vertiefungen (4) der ersten Polymerschicht in Schritt (D) durch Laminieren, Kleben, Klammern, Klemmen, Schrauben oder Nieten erfolgt.

13. Verfahren nach einem der Ansprüche 8 bis 12,
**dadurch gekennzeichnet, dass**
das elektrische Aufladen in Schritt (E) mittels direkter Aufladung oder Coronaentladung geschieht.

14. Verfahren nach einem der Ansprüche 8 bis 13,
**dadurch gekennzeichnet, dass**
vor dem elektrischen Aufladen in Schritt (E) die Hohlräume (5) mit Gasen gefüllt werden, die ausgewählt sind aus der Gruppe umfassend Stickstoff, Stickstoffmonoxid und/oder Schwefelhexafluorid.

15. Piezoelektrisches Element, umfassend einen Polymerschichtenverbund nach einem der Ansprüche 1 bis 7.
